# EUROPEAN PATENT SPECIFICATION

(11) **EP 2 326 891 B1**
(45) Date of publication and mention of the grant of the patent: **12.11.2014**
(21) Application number: 09814830.7
(22) Date of filing: 17.09.2009
(51) Int. Cl.: F24J 2/38, H01L 31/042, F24J 2/54, F24J 2/52, F24J 2/04, H01L 31/0232

(54) **APPARATUS FOR SOLAR TRACKING OF ENERGY HARVESTER**
GERÄT ZUR SONNENVERFOLGUNG EINER STROMGEWINNUNGSVORRICHTUNG
APPAREIL DE POURSUITE DU SOLEIL POUR CAPTEUR D ÉNERGIE

(30) Priority: 18.09.2008 MY 0803638
(43) Date of publication of application: 01.06.2011
(73) Proprietor: Mimos Berhad, 57000 Kuala Lumpur (MY)
(72) Inventor: MUKER-UZ-ZAMAN, A., S., M., 57000 Kuala Lumpur (MY); OTHMAN, Masuri, 57000 Kuala Lumpur (MY); DZUZLINDAH, Muhamad, Alias, 57000 Kuala Lumpur (MY); BHUYAN, Mohammad, Shaharia, 57000 Kuala Lumpur (MY); ZAINUDDIN, Khairul, Hakimin, 57000 Kuala Lumpur (MY); OTHMAN, Abdul, Ghani, 57000 Kuala Lumpur (MY)
(74) Representative: Alton, Andrew
(86) International application number: PCT/MY2009/000150
(87) International publication number: WO 2010/033015

(56) References cited:
- EP-A2- 0 099 663
- EP-A2- 0 155 666
- SU-A1- 1 071 991
- US-A- 4 069 812
- US-A- 4 559 926

## Description

According to the present invention, there is provided an apparatus for solar tracking of an energy harvester according to claim 1.

The invention will now be described in greater detail, by way of an example, with reference to the accompanying drawings, in which:
Fig. 1 illustrates a diagram of a apparatus for solar tracking of a prismatic energy harvester according to the invention; and
Fig. 2A to Fig. 2C illustrate a series of diagram of the rotation of prismatic energy harvester according to the position of the sun.

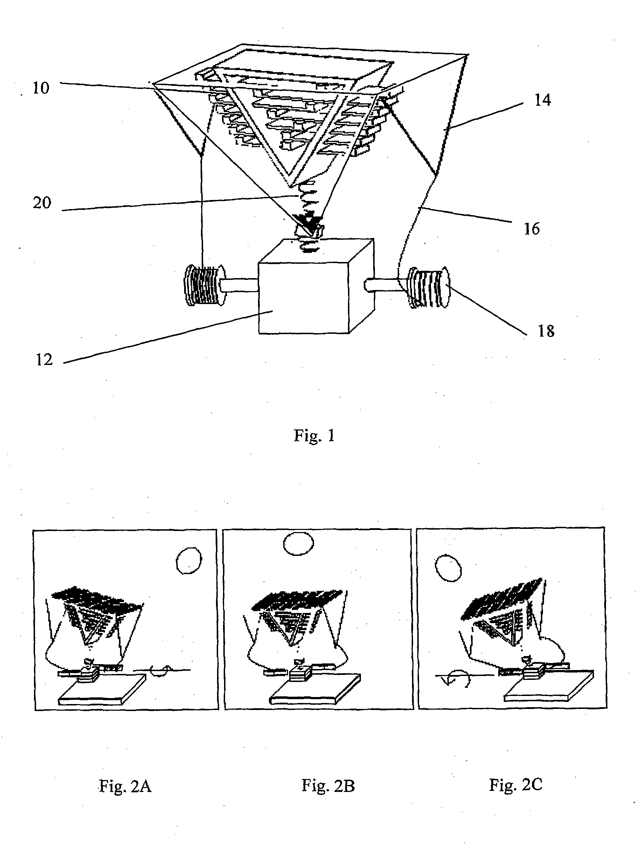

Referring to Fig. 1, there is illustrated an embodiment of a prismatic energy harvester 10 with sun tracker mechanism to rotate the harvester. At least a motor (not shown) is arranged in the box of motor 12. Both side of the top portion of the harvester 10 is clamped with wires which form ears 14, preferably V-shaped ears next to the harvester. A pair of strings 16 from a pair of reels is connected to one end of the ears. The reels 18 are controlled by the box of motor 12.

The prismatic energy harvester 10 is positioned on top of a spring 20. The spring allows the harvester to be floated and required minimal energy to be rotated. Therefore a small rotation of the motor can produce enough power on the string to move the structure according to the position of the sun.

To find the position of the sun, at least two photo-resistive elements are used to track the intensity of sun ray. The photo-resistive elements will be placed inside the box 12, along with the motor and supporting circuitry.

Referring to Fig. 2A, the photo-resistive elements track the position of the sun to sunrise at east. It sends signal to the motor to rotate the reel so that the ear facing east is lowered while the ear facing west is loosen so that the harvester is tilted and facing directly towards the sun. The photo-resistive elements continuously track the sun so that the harvester can be rotated towards the sun at right angle.

Referring to Fig. 2B, the photo-resistive elements track the position of the sun to sun at noon where it is directly above the harvester. It sends signal to the motor to rotate the reel so that

The present invention relates generally to apparatus for energy harvesting, more particularly to apparatus for solar energy harvesting with solar tracker.

For profiling environment in precision agriculture using wireless sensor network, a huge number of low powered devices are required. It is desirable that that these devices harvest their own power using autonomous energy harvester. Solar cell, utilizing solar energy becomes an attractive viable source to complement energy harvester.

The amount of energy harvested form solar cell is dependant on the angle of solar ray induced on the cell. Optimum solar energy is harvested when the solar ray and solar cell are at right angle. However, the sun changes its position all day. As the sun changes its position, the angle of solar ray changes and the solar ray induced on the cell will affect the energy harvested. Therefore, a mechanism is required to change the angle of the solar cell so that it can optimize energy harvesting.

A sun tracker, usually has at least two photo-resistive elements to sense and compare light intensity on a surface of solar cell. If a difference is detected, a motor will adjust the surface of the solar cell to an angle which will produce minimal difference. When there is minimal difference, the incident light received by both photo-resistive elements is parallel. Early sun tracker uses a motor to adjust the solar cell to rotate in a single field.

Another attempt uses multiple sensors and at least two motors to rotate the solar cell in altitude sensor field and azimuth sensor field. The setup requires complex control to obtain an optimum field of view.

The sun may be obscured by clouds. Another embodiment describes a reflective surface on the photo-resistive element to track the sun when the clouds no longer obscure it.

An efficient way of tracking the sun is desirable to optimize energy harvesting of solar energy while minimizing energy waste to rotate the solar cell.

EP-A2-0099663 describes a solar water heating apparatus comprising a housing, an array of concentrators in the housing and a heat exchanger apparatus. Each concentrator is a prismatic body of transparent material.

SU 1071 991 shows an apparatus for solar tracking according to the preamble of claim 1.
both ears have equal length so that the harvester face towards the sun. The photo-resistive elements continuously track the sun so that the harvester can be rotated towards the sun at right angle.

Referring to Fig. 2C, the photo-resistive elements track the position of the sun to sunset at west. It sends signal to the motor to rotate the reel so that the ear facing west is lowered while the ear facing east is loosen so that the harvester is tilted and facing directly towards the sun. The photo-resistive elements continuously track the sun so that the harvester can be rotated towards the sun at right angle.

Accordingly, the invention has a simple apparatus to continuously track the sun with minimal energy. Although the descriptions above contain many specificities, these should not be construed as limiting the scope of the embodiment but as merely providing illustrations of some of the presently preferred embodiments.

## Claims

1. An apparatus for solar tracking comprising:
a prismatic energy harvester (10),
a spring (20) supporting the harvester, **characterized by** a pair of ears (14) on both side of the top portion of the harvester,
a pair of strings (16) connected to one end of the ears,
a pair of reels (18) containing strings (16),
a box of motor (12) which controls the reels, and
at least two photo-resistive elements to track the intensity of sun ray,
wherein the position of the sun is continuously detected by comparing the intensity of sun ray and the motor is directed to adjust the reel so that the harvester is rotated towards the sun at right angle,
whereby the spring allows the harvester to be rotated with minimal energy.

2. The apparatus according to claim 1, wherein the pair of ears (14) are preferably V-shaped ears.

3. The apparatus according to claim 2, wherein the pair of V-shaped ears are made with wires.

## Patentansprüche

1. Vorrichtung zur solaren Nachführung, umfassend:
einen prismenförmigen Energiesammler (10),
eine Feder (20), die den Sammler stützt,
**gekennzeichnet durch**
ein Paar Laschen (14) auf beiden Seiten des oberen Bereichs des Sammlers,
ein Paar Schnüre (16), die mit einem Ende der Laschen verbunden sind,
ein Paar Rollen (18), die die Schnüre (16) aufnehmen,
eine Motorenbox (12), die die Rollen steuert, und
mindestens zwei photoresistive Elemente, um die Intensität von Sonnenstrahlung nachzuverfolgen, wobei die Position der Sonne **durch** Vergleichen der Intensität der Sonnenstrahlung kontinuierlich detektiert wird, und der Motor so gesteuert wird, dass er die Rolle so einstellt, dass der Sammler rechtwinklig zur Sonne hin gedreht wird,
wobei die Feder dem Sammler ermöglicht, mit minimaler Energie gedreht zu werden.

2. Vorrichtung nach Anspruch 1, wobei das Paar Laschen (14) vorzugsweise V-förmige Laschen sind.

3. Vorrichtung nach Anspruch 2, wobei das Paar V-förmiger Laschen mit Drähten gefertigt ist.

## Revendications

1. Appareil pour la poursuite du soleil comprenant :
un collecteur d'énergie prismatique (10),
un ressort (20) supportant le collecteur, **caractérisé par**
une paire d'oreilles (14) sur les deux côtés de la partie supérieure du collecteur,
une paire de cordes (16) reliées à une extrémité des oreilles,
une paire de bobines (18) contenant des cordes (16),
un boîtier de moteur (12) qui commande les bobines, et
au moins deux éléments photorésistants pour poursuivre l'intensité du rayon solaire,
dans lequel la position du soleil est détectée en continu par la comparaison de l'intensité du rayon solaire et le moteur est dirigé pour ajuster la bobine de sorte que le collecteur soit orienté vers le soleil à angle droit,
moyennant quoi le ressort permet au collecteur de tourner avec une énergie minimale.

2. Appareil selon la revendication 1, dans lequel la paire d'oreilles (14) sont de préférence des oreilles en forme de V.

3. Appareil selon la revendication 2, dans lequel la paire d'oreilles en forme de V sont réalisées avec des fils.
